(19) **Europäisches Patentamt**
**European Patent Office**
**Office européen des brevets**

(11) **EP 4 213 273 B1**

(12) **EUROPEAN PATENT SPECIFICATION**

(45) Date of publication and mention
of the grant of the patent:
**01.01.2025 Bulletin 2025/01**

(21) Application number: **22761346.0**

(22) Date of filing: **02.06.2022**

(51) International Patent Classification (IPC):
**H01M 10/44** *(2006.01)* **H02J 7/00** *(2006.01)*

(52) Cooperative Patent Classification (CPC):
**H02J 7/00714; H01M 10/052; H01M 10/44;**
**H01M 50/209;** H01M 10/443; H01M 2220/20;
Y02E 60/10

(86) International application number:
**PCT/CN2022/096897**

(87) International publication number:
**WO 2023/092984 (01.06.2023 Gazette 2023/22)**

(54) **CHARGING METHOD FOR BATTERY, AND BATTERY AND ELECTRICAL ENERGY DEVICE**

LADEVERFAHREN FÜR BATTERIE SOWIE BATTERIE UND ELEKTRISCHE
ENERGIEVORRICHTUNG

PROCÉDÉ DE CHARGE POUR BATTERIE, ET BATTERIE ET DISPOSITIF D'ÉNERGIE
ÉLECTRIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **29.11.2021 CN 202111435377**

(43) Date of publication of application:
**19.07.2023 Bulletin 2023/29**

(73) Proprietor: **Contemporary Amperex Technology
(Hong Kong) Limited
Central, Central And Western District (HK)**

(72) Inventors:
• **XIAO, Qinglin
Ningde, Fujian 352100 (CN)**
• **WU, Yichen
Ningde, Fujian 352100 (CN)**

• **LIU, Zhenwei
Ningde, Fujian 352100 (CN)**
• **YANG, Limei
Ningde, Fujian 352100 (CN)**
• **LIU, Xiaomei
Ningde, Fujian 352100 (CN)**

(74) Representative: **Herrmann, Uwe
Lorenz Seidler Gossel
Rechtsanwälte Patentanwälte
Partnerschaft mbB
Widenmayerstraße 23
80538 München (DE)**

(56) References cited:
**EP-B1- 0 330 981 CN-A- 102 326 313
CN-A- 107 112 791 JP-A- 2014 045 626
JP-A- 2014 068 467 JP-A- 2014 068 467
JP-A- 2014 068 468 JP-A- 2020 149 880**

EP 4 213 273 B1

**Description**

<u>Technical Field</u>

The present application relates to the field of battery charging, and in particular, to a battery charging method, a battery, and an electrical device.

<u>Background Art</u>

During charging and discharging of a battery, the battery cell will swell and thus affect the safety performance of the battery. In addition, with charge and discharge cycling of the battery, an electrolyte is continuously consumed, which may affect the life of the battery. In particular, during the charging of the battery, when a state of charge reaches a certain value, the battery cell may experience a large expansion force, which causes bending of an electrode plate of the battery, thus resulting in a reduced service life of the battery. EP0330981B1 discloses a method of charging a battery. From JP2014068467A, a charge control device is known.

<u>Summary of the Invention</u>

In view of the above problems, the present invention provides a battery charging method according to claim 1, a battery according to claim 11, and an electrical device according to claim 12, which can alleviate the problems of battery safety and affected battery service life due to swelling of a battery during charging.
In a first aspect, the present invention provides a battery charging method, the method including:
during charging of a battery, upon determining that a state of charge (SOC) of the battery reaches a first SOC range, adjusting a charge rate of the battery down to a second charge rate from a first charge rate within a range from a minimum boundary value of the first SOC range to a first set SOC, and adjusting the charge rate of the battery up to the first charge rate or a third charge rate from the second charge rate within a range from the first set SOC to a maximum boundary value of the first SOC range.
In the technical solution of the embodiments of the present application, during charging of the battery, considering a cyclic expansion force of a cell, the first SOC range is set SOC to a maximum boundary value of the first SOC range.
In the technical solution of the embodiments of the present application, during charging of the battery, considering a cyclic expansion force of a cell, the first SOC range is determined based on an SOC corresponding to the expansion force of the battery. The charge rate of the battery is first adjusted down within the first SOC range, such that when the SOC of the battery is close to the first set SOC, the battery is charged at a low charge rate, which reduces the expansion force of the battery, and thus prolongs the service life of the battery.
In the embodiments of the present application, after the charge rate of the battery is reduced to the second charge rate, the second charge rate is maintained for a period of time, such that the expansion force of the battery is kept at a low level, and the service life of the battery is further prolonged.
In the embodiments of the present application, when the SOC of the battery is close to the first set SOC, the battery is charged at a low charge rate, which reduces the expansion force of the battery. When the SOC of the battery exceeds the first set SOC, the charge rate of the battery is further increased. In this way, the expansion force of the battery is reduced near the first set SOC, and the charging efficiency of the battery is improved in a subsequent SOC stage.
In some embodiments, the adjusting the charge rate of the battery up to the first charge rate or a third charge rate from the second charge rate includes:
adjusting the charge rate of the battery up to the third charge rate from the second charge rate when the SOC of the battery reaches a range from the first set SOC to a third SOC; adjusting the charge rate of the battery down to the second charge rate from the third charge rate when the SOC of the battery reaches a range from the third SOC to a fourth SOC; and adjusting the charge rate of the battery up to the first charge rate from a fourth charge rate when the SOC of the battery reaches a range from the fourth SOC to the maximum boundary value of the first SOC range.
In the embodiments of the present application, when the SOC of the battery is close to the first set SOC, the battery is charged at a low charge rate, which reduces the expansion force of the battery. When the SOC of the battery exceeds the first set SOC, the charge rate of the battery is further increased to improve the charging efficiency of the battery. When the charge rate reaches a certain value, the charge rate of the battery is further reduced, and is then increased to the previous first charge rate after being reduced to the second charge rate, for example. In this way, the charging efficiency of the battery is ensured, and the service life of the battery is also prolonged.
In the embodiments of the present application, in order to ensure the charging efficiency of the battery, the battery is charged at a high charge rate from the start of charging to the minimum value of the first SOC range. When the SOC of the battery is within the first SOC range, the charge rate of the battery is adjusted down to the second charge rate from the first charge rate, such that the charge rate is quickly reduced to the minimum value, which may prevent a large expansion force of the battery. Subsequently, after the SOC of the battery is greater than the first set SOC, the charge rate of the battery is quickly increased to the third charge rate. When the SOC of the battery exceeds the maximum boundary value of the first SOC range, the battery is charged in a charging mode greater than the first charge rate. In this way, the charging efficiency of the battery can be greatly improved.

In some embodiments, the first set SOC ranges from 24.5% to 25.5%, and varies depending on ambient temperature.

In the embodiments of the present application, the first set SOC is determined depending on a type, temperature, etc. of the battery. In order to ensure the service life of the battery, a charging current is greatly reduced near the first set SOC, such that the expansion force of the battery is greatly reduced, and the service life of the battery is thus prolonged.

In some embodiments, the first set SOC includes: 24.7%, 24.8%, 24.9%, 25%, 25.1%, 25.2%, or 25.3%.

In the embodiments of the present application, the first set SOC is determined depending on a type, temperature, etc. of the battery, such that during the charging of the battery, the charge rate of the battery is reduced near the first set SOC, thereby improving the service life of the battery.

In some embodiments, the first SOC range includes: 20%-40%.

In the embodiments of the present application, the first SOC range is determined depending on battery characteristics, a service environment temperature of the battery, etc., in which interval the charging current of the battery is reduced, thereby improving the service life of the battery.

In a second aspect, the present invention provides a battery including a battery cell, which is provided with corresponding electrical power after being charged using a battery charging method as described.

In a third aspect, the present invention provides an electrical device, which includes a device body and a power source, where a battery as described is used as the power source.

The aforementioned description is only an overview of the technical solutions of the present application. In order to more clearly understand the technical means of the present application to implement same according to the contents of the specification, and in order to make the aforementioned and other objects, features and advantages of the present application more obvious and understandable, specific embodiments of the present application are exemplarily described below.

## Brief Description of the Drawings

Various other advantages and benefits will become apparent to those of ordinary skill in the art upon reading the following detailed description of preferred embodiments. The drawings are merely for the purpose of illustrating the preferred embodiments and are not to be construed as limiting the present application. Moreover, like components are denoted by like reference numerals throughout the drawings. In the drawings:

FIG. 1 is a schematic structural diagram of a vehicle provided in some embodiments of the present application;

FIG. 2 is a schematic diagram of charging stage and charging current according to some embodiments of the present application;

FIG. 3 is schematic diagram 1 of a battery charging strategy according to some embodiments of the present application;

FIG. 4 is schematic diagram 2 of a battery charging strategy according to some embodiments of the present application;

FIG. 5 is a schematic diagram of charging stage and charging current according to some embodiments of the present application;

FIG. 6 is schematic diagram 1 of a battery charging strategy according to some embodiments of the present application;

FIG. 7 is schematic diagram 2 of a battery charging strategy according to some embodiments of the present application;

FIG. 8 is schematic diagram 3 of a battery charging strategy according to some embodiments of the present invention;

FIG. 9 is schematic diagram 4 of a battery charging strategy according to some embodiments of the present application;

FIG. 10 is a schematic diagram of a relationship between minimum charge rate and temperature according to some embodiments of the present application.

## Detailed Description of Embodiments

Embodiments of the technical solutions of the present application will be described in more detail below with reference to the drawings. The following embodiments are merely intended to more clearly illustrate the technical solutions of the present application, so they merely serve as examples, but are not intended to limit the scope of protection of the present application.

Unless otherwise defined, all technological and scientific terms used herein have the same meanings as those commonly understood by those skilled in the art to which the present application belongs. The terms used herein are merely for the purpose of describing specific embodiments, but are not intended to limit the present application. The terms "comprising" and "having" and any variations thereof in the description and the claims of the present application as well as the brief description of the drawings described above are intended to cover non-exclusive inclusion.

In the description of the embodiments of the present application, the technical terms "first", "second", etc. are merely used for distinguishing different objects, and are not to be construed as indicating or implying relative importance or implicitly indicating the number, particular order or primary-secondary relationship of the technical features modified thereby. In the description of the embodiments of the present application, the phrase "a plurality of" means two or more, unless otherwise explicitly and specifically defined.

The phrase "embodiment" mentioned to herein means that the specific features, structures and characteristics described in conjunction with the embodiment may be included in at least one of the embodiments of the present application. The phrase at various locations in the specification does not necessarily refer to the same embodiment, or an independent or alternative embodiment exclusive of another embodiment. Those skilled in the art understand explicitly or implicitly that an embodiment described herein may be combined with another embodiment.

In the description of the embodiments of the present application, the term "and/or" is merely intended to describe the associated relationship of associated objects, representing that three relationships can exist, for example, A and/or B can include: the three instances of A alone, A and B simultaneously, and B alone. In addition, the character "j" herein generally indicates an "or" relationship between the associated objects.

In the description of the embodiments of the present application, the term "a plurality of" means two or more (including two), similarly the term "a plurality of groups" means two or more groups (including two groups), and the term "a plurality of pieces" means two or more pieces (including two pieces).

In the description of the embodiments of the present application, the orientation or position relationship indicated by the technical terms "central", "longitudinal", "transverse", "length", "width", "thickness", "upper", "lower", "front"; "rear", "left", "right", "vertical", "horizontal", "top", "bottom", "inner", "outer", "clockwise", "counterclockwise", "axial", "radial", "circumferential", etc. are based on the orientation or position relationship shown in the drawings and are merely intended to facilitate and simplify the description of the embodiments of the present application, rather than indicating or implying that the device or element considered must have a particular orientation or be constructed and operated in a particular orientation, and therefore not to be construed as limiting the embodiments of the present application.

In the description of the embodiments of this application, unless otherwise explicitly specified and defined, the technical terms "mounting", "mutual connection", "connection" and "fixing" should be understood in a broad sense, for example, they may be a fixed connection, a detachable connection, or an integrated connection; may be a mechanical connection or an electrical connection; and may be a direct connection or an indirect connection through an intermediate medium, and may be communication between interiors of two elements or interaction between the two elements. For those of ordinary skill in the art, the specific meaning of the above terms in the embodiments of the present application can be understood according to specific situations.

At present, from the perspective of the development of the market situation, the application of traction batteries is widespread increasingly. The traction batteries are not only used in energy storage power systems such as hydroelectric power plants, thermal power plants, wind power plants and solar power plants, but also widely used in electric transportation means such as electric bicycles, electric motorcycles and electric vehicles and in many fields such as military equipment and aerospace. With the continuous expansion of the application field of traction batteries, the market demand for the traction batteries is also increasing.

The inventors have noticed that taking a method for charging a lithium battery as an example, a charging strategy thereof includes a reduced-order constant-current and constant-voltage charging strategy, which includes a plurality of charging stages, where there is a constant current in each charging stage; in two adjacent charging stages, the constant current in the previous charging stage is greater than the constant current in the next charging stage; a voltage between an end node of the previous charging stage and a start node of the next charging stage remains unchanged, and a current therebetween decreases; and in each charging stage, a voltage at the end node is higher than a voltage at the start node. In two adjacent charging stages, there is a transition stage between the end node of the previous charging stage and the start node of the next charging stage. The transition stage can allow for continuous charging of the battery so that the battery can be fully charged faster, which improves the charging speed of the lithium battery. However, it is not considered in the above-mentioned charging method for a battery that, when the battery is at or near a certain SOC, the battery cell may experience a large expansion force, in which case the charge rate of the battery should be appropriately reduced to reduce the expansion force of the battery. Instead, in most of current charging methods, only the charging efficiency and charging time are considered, but not the expansion force of the battery, the service life of the battery, etc.

In order to alleviate the problem of the expansion force of the battery during the charging stage, the applicant has found through research that during the charging of the battery, when at or near a certain SOC, the battery may experience an excessively large expansion force and it is not conducive to charging the battery at a high charge rate, and at this time, the charge rate should be reduced to reduce the expansion force of the battery. Therefore, the charge rate of the battery should be reduced in some intervals of SOC to prolong the service life of the battery, and the charge rate of the battery can be increased in other intervals of SOC.

The battery charging method disclosed in the embodiments of the present application can be used to charge a lithium battery, a lithium iron phosphate battery, etc., which can ensure both the service life of the battery and the charging efficiency of the battery. A battery using the charging method of the embodiments of the present application can be used in power consuming apparatuses such as vehicles, ships, or aircrafts.

The embodiments of the present application provide a power consuming apparatus using a battery, which uses a charing method, as a power source, and the power consuming apparatus may be, but is not limited to, a mobile phone, a tablet, a laptop computer, an electric toy, an electric tool, a battery car, an electric vehicle, a ship, a space vehicle, or the like. The electric toy may include stationary or mobile electric toys, for example, game consoles, electric car toys, electric ship toys and electric airplane toys. The spacecraft may include airplanes, rockets, space shuttles, spaceships, etc.

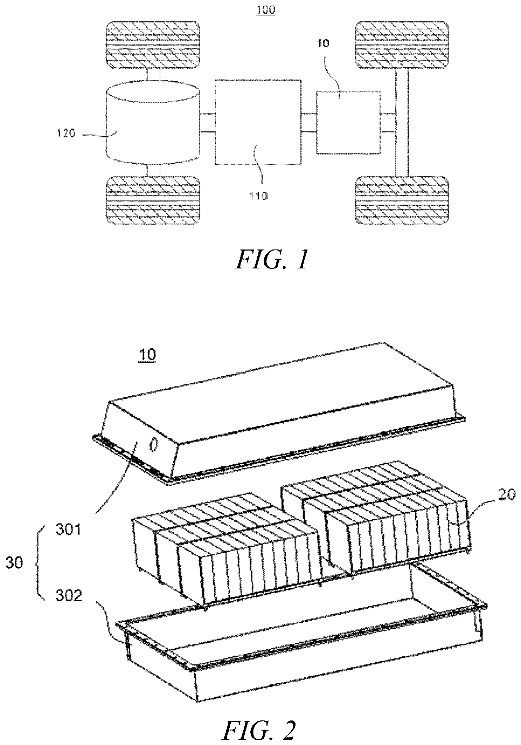

Referring to FIG. 1, FIG. 1 is a schematic structural diagram of a vehicle 100 provided in some embodiments of the present application. The vehicle 100 may be a fuel vehicle, a gas vehicle, or a new energy vehicle. The new energy vehicle may be a battery electric vehicle, a hybrid electric vehicle, an extended-range vehicle, etc. A battery 10 is provided inside the vehicle 100, and the battery 10 may be provided at the bottom, the front or the back of the vehicle 100. The battery 10 may be used for power supply for the vehicle 100. For example, the battery 10 may serve as an operating power source of the vehicle 100. The vehicle 100 may further include a controller 110 and a motor 120, and the controller 110 is used to control the battery 10 to supply power to the motor 120, for example, to satisfy the working power requirements during the starting, navigation and traveling of the vehicle 100.

In some embodiments of the present application, the battery 10 can not only serve as an operating power source for the vehicle 100, but also serve as a driving power source for the vehicle 100, instead of or partially instead of fuel or natural gas, to provide driving power for the vehicle 100.

The battery 10 may include a plurality of battery cells 210 in order to meet different power demands, where the battery cell 210 is the smallest unit of a battery module or a battery pack. The plurality of battery cells 210 may be connected together in series and/or in parallel via electrode terminals, for use in various application scenarios. The battery mentioned in the present application includes a battery module or a battery pack. The plurality of battery cells 210 may be connected in series or in parallel or in a hybrid manner, and the hybrid connection means a mixture of the serial connection and the parallel connection. The battery 10 may also be referred to as a battery pack. In the embodiments of the present application, the plurality of battery cells 210 may directly form a battery pack, or may first form battery modules 20, and the battery modules 20 may then form a battery pack.

FIG. 2 is a schematic structural diagram of a battery 10 according to an embodiment of the present application. In FIG. 2, the battery 10 may include a plurality of battery modules 20 and a case 30, and the plurality of battery modules 20 are accommodated in the case 30. The case 30 is used for accommodating a battery cell 210 or the battery modules 20, to prevent liquid or other foreign objects from affecting the charging or discharging of the battery cell 210. The case 30 may be a simple three-dimensional structure such as a single cuboid, cylinder or sphere, or a complex three-dimensional structure composed of simple three-dimensional structures such as a cuboid, a cylinder or a sphere, which will not be limited in the embodiments of the present application. The case 30 may be made of an alloy material such as aluminum alloy or ferroalloy, a polymer material such as polycarbonate or polyisocyanurate foam plastic, or a composite material such as glass fibers and epoxy resin, which will also not be limited in the embodiments of the present application.

In some embodiments, the case 30 may include a first portion 301 and a second portion 302. The first portion 301 and the second portion 302 are fitted to each other in a covered manner. The first portion 301 and the second portion 302 together define a space for accommodating the battery cell 210. The second portion 302 may be of a hollow structure with one end open, the first portion 301 may be of a plate-like structure, and the first portion 301 is fitted to the open side of the second portion 302 in a covered manner so that the first portion 301 and the second portion 302 together define a space for accommodating the battery cell 210; and the first portion 301 and the second portion 302 may also be of a hollow structure with one side open, and the open side of the first portion 301 is fitted to the open side of the second portion 302 in a covered manner.

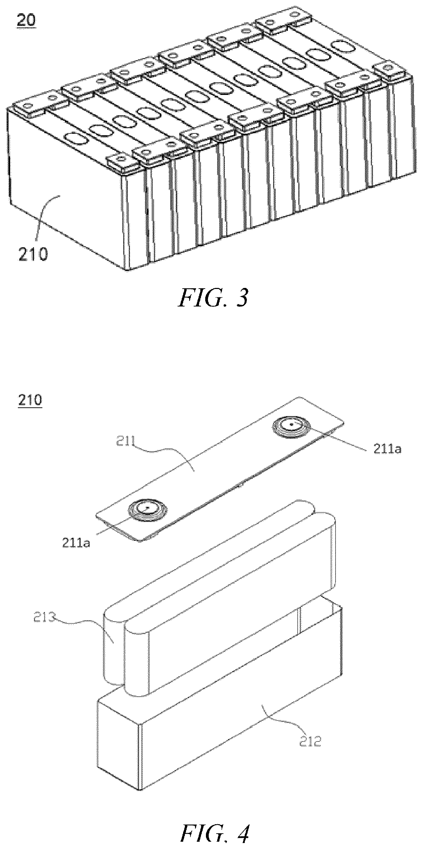

FIG. 3 is a schematic structural diagram of a battery module 20 according to an embodiment of the present application. In FIG. 3, the battery module 20 may include a plurality of battery cells 210. The plurality of battery cells 210 may be first connected in series or in parallel or in a hybrid connection to form a battery module 20, and the plurality of battery modules 20 may be then connected in series or in parallel or in a hybrid connection to form a battery 10. In the present application, the battery cell 210 may include a lithium ion battery cell, a sodium ion battery cell, a magnesium ion battery cell, etc., which will not be limited in the embodiments of the present application. The battery cell 210 may be in a cylindrical shape, a flat shape, a cuboid shape or another shape, which is also not limited in the embodiments of the present application. The battery cells 210 are generally classified into three types depending on the way of package: cylindrical battery cells 210, prismatic battery cells 210 and pouch battery cells 210, which will also not be limited in the embodiments of the present application. However, for the sake of brevity, the following embodiments will be described by taking the prismatic battery cells 210 as an example.

FIG. 4 is an exploded schematic structural diagram of a battery cell 210 provided in some embodiments of the present application. The battery cell 210 is the smallest unit of a battery. As shown in FIG. 4, the battery cell 210 includes an end cover 211, a housing 212, and a cell assembly 213.

The end cover 211 is a component that covers an opening of the housing 212 to isolate an internal environment of the battery cell 210 from an external environment. Without limitation, the end cover 211 may be adapted to the housing 212 in shape, to fit with the housing 212. Optionally, the end cover 211 may be made of a material with a certain degree of hardness and strength (such as aluminum alloy) so that the end cover 211 is not easily deformed when being squeezed and collided, and therefore, the battery cell 210 can have a higher degree of structural strength and the safety performance of the battery cell can also be improved. The end cover 211 may be provided with functional components such as electrode terminals 211a. The electrode terminals 211a may be used for electrical connection with the cell assembly 213 for outputting or inputting electrical power of the battery cell 210. In some embodiments, the end cover 211 may also be provided with a pressure relief mechanism for releasing an internal pressure when the internal pressure or temperature of the battery cell 210 reaches a threshold. The end cover 211 may also be made of various materials, such as copper, iron, aluminum, stainless steel, aluminum alloy, and plastic, which is not particularly limited in the embodiments of the present application. In some embodiments, an insulating component may also be provided on an inner side of the end cover 211. The insulating component may be used to isolate electrical connection components in the housing 212 from the end cover 211 to reduce a risk of short circuit. Exemplarily, the insulating component may be plastic, rubber, etc.

The housing 212 is an assembly that is used to fit with the end cover 211 to form the internal environment of the battery cell 210, where the formed internal environment can be used for accommodating the cell assembly 213, an electrolyte (not shown in the figure) and other components. The housing 212 and the end cover 211 may be separate components. The housing 212 may be provided with an opening, which is covered by the end cover 211 to form the internal environment of the battery cell 210. Without limitation, the end cover 211 and the housing 212 may also be integrated. Specifically, the end cover 211 and the housing 212 can first form a common connection surface before other components are placed into the housing, and the end cover 211 then covers the housing 212 when the interior of the housing 212 needs to be packaged. The housing 212 may be of various shapes and various sizes, for example, in the shape of a cuboid, a cylinder, a hexagonal prism, etc. Specifically, the shape of the housing 212 may be determined depending on the specific shape and size of the cell assembly 213. The housing 212 may be made of various materials, such as copper, iron, aluminum, stainless steel, aluminum alloy, and plastic, which is not particularly limited in the embodiments of the present application.

The cell assembly 213 is a component, where an electrochemical reaction occurs, in the battery cell 210. The housing 212 may include one or more cell assemblies 213. The cell assembly 213 is mainly formed by winding or stacking a positive electrode plate and a negative electrode plate, and a separator is usually provided between the positive electrode plate and the negative electrode plate. Parts of the positive electrode plate and the negative electrode plate that have an active material constitute a main body of the cell assembly, and parts of the positive electrode plate and the negative electrode plate that have no active material each constitute a tab (not shown in the figure). The positive electrode tab and the negative electrode tab can be located at one end of the main body or at both ends of the main body. During the charging and discharging of the battery, the positive active material and the negative active material react with the electrolyte, and the tabs are connected to the electrode terminals to form a current loop.

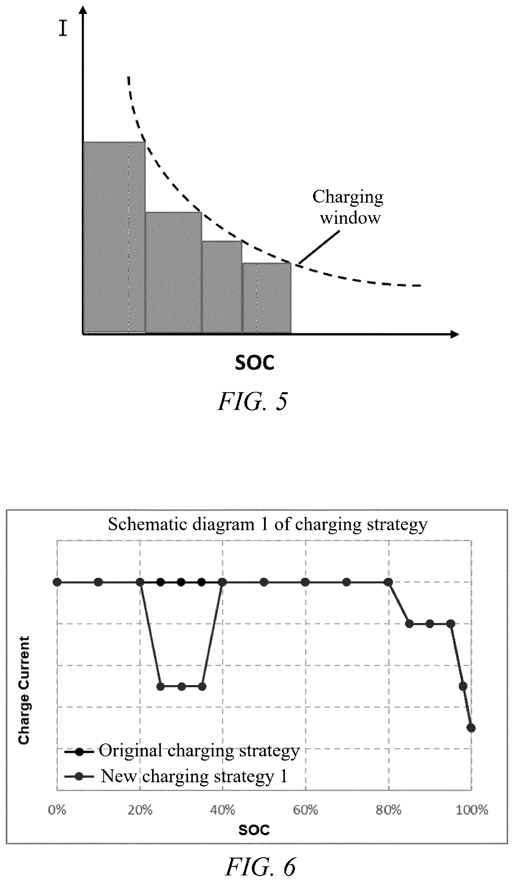

Referring to FIG. 5, FIG. 5 is a schematic diagram of charging stage and charging current. At present, common step charging strategies include: a reduced-order constant-current and constant-voltage charging strategy, which includes a plurality of charging stages, where there is a constant charging current in each charging stage; in every two adjacent charging stages, the constant current in the previous charging stage is greater than the constant current in the next charging stage; a charging voltage between an end node of the previous charging stage and a start node of the next charging stage thereof remains unchanged, and a charging current therebetween decreases; and in each charging stage, a voltage at the end node is higher than a voltage at the start node.

In the embodiments of the present application, a new charging strategy is proposed for a battery cell based on its system characteristics, which can effectively exert the cycling performance of the cell and prolong the cycling life of the cell. Specifically, in a region where a lithium battery experiences an extremely large expansion force, current reduction is appropriately carried out. In this way, the polarization accumulation of the cell during cycling is reduced, the cycling performance of the cell is efficiently exerted, and the cycling life of the cell is prolonged. In the embodiments of the present application, in an interval of 0%-80% SOC of the battery, a specific SOC for which the charge rate of the battery needs to be reduced is determined, and the charge rate thereof is reduced at the determined SOC.

In the embodiments of the present application, the charge rate is a measure of speed at which a battery is charged. It refers to a current value required to charge the battery to its rated capacity within a specified time. It is numerically equal to a rate of the battery rated capacity, that is, charging current / battery rated capacity = charge rate. After discharging of a battery, a direct current is allowed to pass through the battery in an opposite direction to a discharging current so that the battery restores its working. This process is called battery charging. During charging the battery, a positive electrode of the battery is connected to a positive pole of a power source, and a negative electrode of the battery is connected to a negative pole of the power source. A voltage of a charging power supply must be higher than a total electromotive force of the battery. There are two charging methods, namely a constant-current charging method and a constant-voltage charging method.

The constant-current charging method is a method for adjusting an output voltage of a charging apparatus or changing a series resistance of a battery to keep a charging current intensity unchanged. This control method is simple. However, since an acceptable current capacity of the battery gradually declines with a charging process, in a later stage of charging, the charging current is mostly used for electrolyzing water, generating gas, and making the gas out too much. Therefore, a stage charging method is often used.

A voltage of a charging power supply maintains a constant value throughout the charging time, and as a terminal voltage of the battery gradually increases, the current thereof gradually decreases. The constant-voltage charging method has a charging process closer to an optimal charging curve as compared with the constant-current charging method. With constant-voltage fast charging, an electromotive force of a battery is low at the beginning of charging, with a large charging current, and as the charging progresses, the current will gradually decrease. Therefore, only a simple control system is required.

According to some embodiments of the present application, during charging of a battery, upon determining that a state of charge (SOC) of the battery reaches a first SOC range, a charge rate of the battery is adjusted down to a second charge rate from a first charge rate within a range from a minimum boundary value of the first SOC range to a first set SOC, and the charge rate of the battery is adjusted up to the first charge rate or a third charge rate from the second charge rate within a range from the first set SOC to a maximum boundary value of the first SOC range.

The battery charging method of the embodiments of the present application is similar to an existing battery charging method, that is, the battery is charged at a large charge rate in an initial charging stage of the battery, and when the SOC of the battery is within the first SOC range, as the SOC continuously increases from a low level, the charge rate of the battery is adjusted first down and then up. In the embodiments of the present application, during cycling of cells of a battery system, it has found, based on the temperature in an environment where the battery is located and a large number of experiments, that the expansion force of the battery is maximized when the SOC of the battery is near 25%. Therefore, during charging, when the SOC is close to 25%, the battery is charged at a low current. In this way, the level of deterioration of a polarization window due to the maximized expansion is reduced, and the performance of the cells is exerted more efficiently. In other words, the charging strategy in the embodiments of the present application exhibits an obvious characteristic of a concave area, that is, the charge rate of the battery is first decreased and then increased. In other words, in an interval of 0%-80% SOC of the battery, the concave area appears in an interval of 20%-40% SOC, and an extremely low value of the charge rate appears at 25% SOC.

In the technical solution of the embodiments of the present application, during charging of a battery, considering a cyclic expansion force of a cell, a first SOC range is determined based on an SOC corresponding to the expansion force of the battery. When a state of charge (SOC) of the battery reaches the first SOC range, a charge rate of the battery is adjusted down to a second charge rate from a first charge rate within a range from a minimum boundary value of the first SOC range to a first set SOC, and the charge rate of the battery is adjusted up to the first charge rate or a third charge rate from the second charge rate within a range from the first set SOC to a maximum boundary value of the first SOC range, such that when the SOC of the battery is close to the first set SOC such as 25%, the battery is charged at a low charge rate, which reduces the expansion force of the battery, and thus prolongs the service life of the battery. When the SOC of the battery exceeds the first set SOC, the charge rate of the battery should be increased as early as possible, to ensure the charging efficiency of the battery. Here, the third charge rate is greater than the first charge rate.

The essence of the technical solution of the embodiments of the present application will be further illustrated below by way of specific examples.

According to some embodiments of the present application, the adjusting the charge rate of the battery up to the first charge rate or a third charge rate from the second charge rate includes: maintaining the charge rate of the battery at the second charge rate when the SOC of the battery reaches a range from the first set SOC to a second SOC; and adjusting the charge rate of the battery up to the first charge rate from the second charge rate when the SOC of the battery reaches a range from the second SOC to the maximum boundary value of the first SOC range.

Referring to FIG. 6, FIG. 6 is schematic diagram 1 of a battery charging strategy according to some embodiments of the present application. In an interval of 0%-80% SOC of the battery, a conventional charging strategy is constant-current charging. However, taking a charging environment temperature of the battery of 25°C as an example, compared with the conventional charging strategy, a new charging strategy of the embodiments of the present application exhibits an obvious trend of reduction in current in an interval of 20%-40% SOC, and enables constant-current charging in an interval of 25%-35% SOC, with a charge rate thereof being between 0.2 and 0.8 times the original charge rate. Through this strategy, the performance of the cell can be effectively exerted, and the life of the cell can be extended. As an implementation, the charge rate F(25%) = F(30%) = F(35%) = 0.42*F(20%). In other words, in an interval of 0%-20% SOC, the charge rate is kept the same as the charge rate of the existing charging strategy. In an interval of 20%-25% SOC, the charge rate is reduced to 0.42 times the original charge rate, that is, the original charge rate is reduced to 0.42 times thereof. In an interval of 30%-35% SOC, the charge rate of the battery is maintained to be 0.42 times the original charge rate (20% SOC). In an interval of 35%-40% SOC, the charge rate of the battery is increased to the original charge rate, that is, the charge rate with an SOC of 20%. In an interval of 40%-80% SOC, the charge rate with an SOC of 20% is maintained. In an interval of 80%-100% SOC, the charge rate is decreased, and is thus kept the same as that in the existing battery charging strategy.

According to some embodiments of the present application, the foregoing first charge rate includes the charge rate with an SOC of 20%, and the second charge rate includes the charge rate with an SOC of 30% to 35%, that is, 0.42 times the charge rate with an SOC of 20%. In the embodiments of the present application, the second charge rate may also be any rate from 0.2 times to 0.8 times the charge rate with an SOC of 20%, such as 0.28 times, 0.35 times, 0.45 times, or 0.56 times, which is specifically determined depending on the expansion force of the battery during charging, with a purpose of reducing the expansion force of the battery during charging.

According to some embodiments of the present application, the adjusting the charge rate of the battery up to the first charge rate or a third charge rate from the second charge rate includes: adjusting the charge rate of the battery up to the first charge rate from the second charge rate when the SOC of the battery reaches the range from the first set SOC to the maximum boundary value of the first SOC range. When the SOC is close to the first set SOC, the charge rate is reduced to a minimum value, and when the SOC exceeds the first set SOC, the charge rate of the battery is increased. In other words, when the SOC is close to the first set SOC, the charge rate of the battery is reduced to the minimum value in order to prevent the deterioration of a polarization window due to the maximized expansion of the battery, and when the SOC exceeds the first set SOC, the charge rate of the battery is increased.

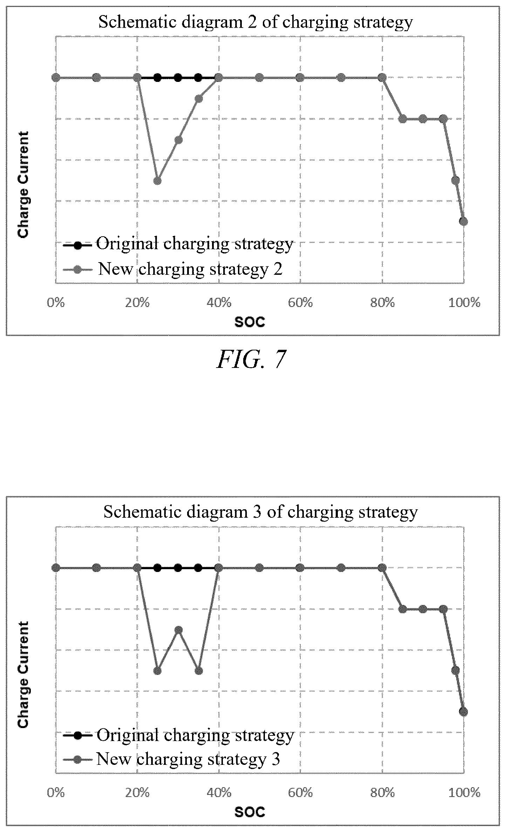

Referring to FIG. 7, FIG. 7 is schematic diagram 2 of a battery charging strategy according to some embodiments of the present application. Taking 25°C as an example, compared with the conventional charging strategy, the new charging strategy of the embodiments of the present application exhibits an obvious trend of reduction in current in an interval of 0%-40% SOC, and enables step charging in an interval of 25%-40% SOC (incremental steps as shown in FIG. 7), with a charge rate thereof being between 0.2 and 0.8 times the original charge rate. Each temperature corresponds to an optimal ratio. In the embodiments of the present application, the performance of the cell can be effectively exerted and the life of the cell can be extended by using the strategy. The charging strategy is as follows:

$$F(25\%) = 0.42*F(20\%) < F(30\%) < F(35\%) < F(40\%).$$

According to the charging strategy shown in FIG. 7, in an interval of 0%-20% SOC of the battery, the charge rate is kept the same as the charge rate of the existing charging strategy. In an interval of 20%-25% SOC, the charge rate is reduced to 0.42 times the original charge rate, that is, the original charge rate is reduced to 0.42 times. Moreover, in an interval of 25%-40% SOC, the charge rate of the battery is increased to the original charge rate. In an interval of 40%-80% SOC, the charge rate with an SOC of 20% is maintained. In an interval of 80%-100% SOC, the charge rate is decreased, and is thus kept the same as that in the existing battery charging strategy.

In the interval of 25%-40% SOC, the charge rate scheme is as follows:

F(25%) = 0.42 (F corresponding to 20% SOC);
F(30%) = 0.6 (F corresponding to 20% SOC); and
F(35%) = 0.7 (F corresponding to 20% SOC).

In the interval of 25%-40% SOC, the charge rate scheme is as follows:

F(25%) = 0.42 (F corresponding to 20% SOC);
F(30%) = 0.5 (F corresponding to 20% SOC); and
F(35%) = 0.6 (F corresponding to 20% SOC).

According to some embodiments of the present application, the second charge rate includes a rate of 0.42 times the charge rate with an SOC of 20% (the charge rate with an SOC of 0% to 20%). The second charge rate may also be any rate from 0.2 times to 0.8 times the charge rate with an SOC of 20%, such as 0.28 times, 0.35 times, 0.45 times, or 0.56 times, which is specifically determined depending on the expansion force of the battery during charging, with a purpose of reducing the expansion force of the battery during charging.

According to some embodiments of the present application, the adjusting the charge rate of the battery up to the first charge rate or a third charge rate from the second charge rate includes: adjusting the charge rate of the battery up to the third charge rate from the second charge rate when the SOC of the battery reaches a range from the first set SOC to a third SOC; adjusting the charge rate of the battery down to the second charge rate from the third charge rate when the SOC of the battery reaches a range from the third SOC to a fourth SOC; and adjusting the charge rate of the battery up to the first charge rate from a fourth charge rate when the SOC of the battery reaches a range from the fourth SOC to the maximum boundary value of the first SOC range, such that the charge rate of the battery is represented in a jagged form. The fourth charge rate is greater than the second charge rate.

Referring to FIG. 8, FIG. 8 is schematic diagram 3 of a battery charging strategy according to the present invention. Taking 25°C as an example, compared with the conventional charging strategy, the new charging strategy of the embodiments of the present application exhibits an obvious trend of reduction in current in an interval of 20%-40% SOC, and enables step charging in an interval of 25%-40% SOC ("jagged" step charging as shown in the figure), with a charge rate thereof being between 0.2 and 0.8 times the original charge rate in the case of 25% SOC (there is an optimal ratio for each temperature). Through this strategy, the performance of the cell can be effectively exerted, and the life of the cell can be extended.

According to some embodiments of the present application, in an interval of 0%-20% SOC, the charge rate is kept the same as the charge rate of the existing charging strategy. In an interval of 20%-25% SOC, the charge rate is reduced to 0.42 times the original charge rate, that is, the original charge rate is reduced to 0.42 times thereof. Moreover, in an interval of 25%-30% SOC, the charge rate of the battery is increased to 0.6 times the original charge rate. Here, 0.6 times original charge rate is the fourth charge rate. The fourth charge rate may also be 0.65 times, 0.5 times, etc. the original charge rate, as long as it is greater than the second charge rate. In an interval of 30%-35% SOC, the charge rate of the battery is further reduced from 0.6 times the original charge rate to 0.42 times the original charge rate. In an interval of 35%-40% SOC, the charge rate of the battery is increased from 0.42 times the original charge rate to the charge rate of the original charging strategy. In an interval of 40%-80% SOC, the charge rate with an SOC of 20% is maintained. In an interval of 80%-100% SOC, the charge rate is decreased, and is thus kept the same as that in the existing battery charging strategy.

According to some embodiments of the present application, for the minimum charge rate, a relationship between rates of the charge rate with an SOC of 20% determined based on ambient temperature is shown in Table 1 below:

Table 1

| Temperature (°C) | Relationship between rates |
| --- | --- |
| 20 | 0.33 |
| 25 | 0.42 |
| 30 | 0.5 |
| 35 | 0.59 |
| 40 | 0.7 |
| 45 | 0.8 |

According to some embodiments of the present application, the adjusting the charge rate of the battery up to the first charge rate or a third charge rate from the second charge rate includes:

adjusting the charge rate of the battery up to the third charge rate from the second charge rate when the SOC of the battery reaches the range from the first set SOC to the maximum boundary value of the first SOC range, where the third charge rate is greater than the first charge rate. The battery is charged by using a charging strategy of decreasing from a fifth charge rate to the first charge rate, when the SOC of the battery ranges from zero to the minimum boundary value of the first SOC range. The charge rate of the battery is adjusted up to a sixth charge rate from the third charge rate and then down to the first charge rate from the sixth charge rate, when the SOC of the battery reaches a range from the maximum boundary value of the first SOC range to a fifth SOC.

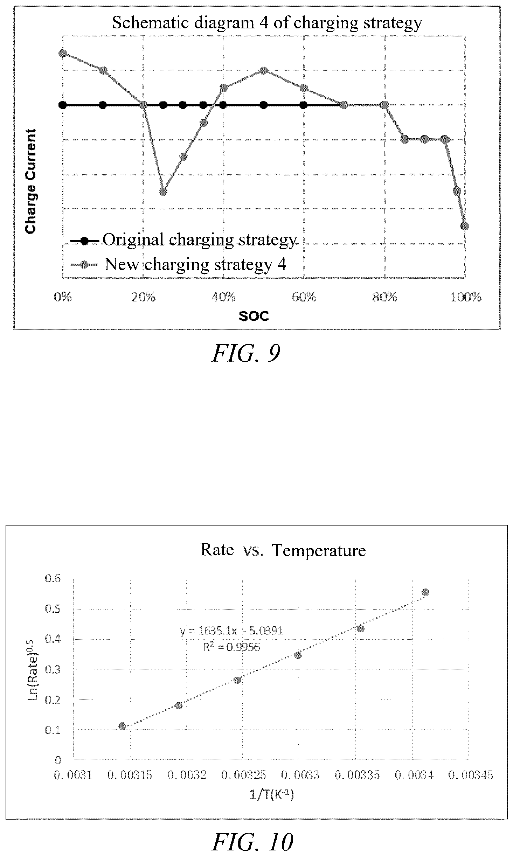

Referring to FIG. 9, FIG. 9 is schematic diagram 4 of a battery charging strategy according to some embodiments of the present application. Taking 25°C as an example, in the interval of 0%-20% SOC of the battery, the battery charging strategy enables the charge rate to be directly increased to 1.4 times, etc. the original charge rate of the original battery charging strategy, or to be at least greater than the original charge rate of the original battery charging strategy (within a lithium precipitation window). In other words, an initial charge rate for charging the battery can be directly adjusted to be 1.4 times the charge rate of the original battery charging strategy. Here, the charge rate that is 1.4 times the original charge rate is the fifth charge rate, which has a value that is set according to situations, and the charge rate may also be 1.3 times, etc. the original charge rate. In the interval of 0%-20% SOC, the charge rate of the battery is gradually reduced to the charge rate of the original battery charging strategy. In a stage of 20%-25% SOC, the charge rate is reduced to 0.42 times the original charge rate by using case 2 shown in FIG. 7, that is, the original charge rate is reduced to 0.42 times thereof. Moreover, in an interval of 25%-40% SOC, the charge rate of the battery is increased to the original charge rate. Specifically, in the interval of 25%-40% SOC, the charge rate of the battery is increased from 0.42 times the original charge rate to 1.1 times the charge rate of the original charging strategy. In an interval of 40%-50% SOC, the charge rate of the battery is increased from 1.1 times the original charge rate to 1.2 times the charge rate of the original charging strategy. In an interval of 50%-70% SOC, the charge rate of the battery is reduced from 1.2 times the original charge rate to the charge rate of the original charging strategy. In an interval of 70%-80% SOC, the charge rate of the battery is maintained at the charge rate of the original charging strategy; and in an interval of 80%-100% SOC, the charge rate is decreased, and is thus kept the same as that in the existing battery charging strategy. In this example, the cycling life of the cell is improved under the premise that the overall charging time of the battery is basically the same as that of the battery in the original charging strategy.

According to some embodiments of the present application, the foregoing first set SOC ranges from 24.5% to 25.5%, and varies depending on ambient temperature. The first set SOC may include: 24.7%, 24.8%, 24.9%, 25%, 25.1%, 25.2%, or 25.3%.

Referring to FIG. 10, FIG. 10 is a schematic diagram of a relationship between minimum charge rate and temperature according to some embodiments of the present application. A correspondence between minimum charge rate set in the foregoing embodiments and ambient temperature of the battery is roughly linear, as shown in Table 2 below:

Table 2

| Temperature (°C) | Kelvin temperature (K) | Reciprocal Kelvin temperature (1/K) | Rate | Square root calculation | Numerical value |
|---|---|---|---|---|---|
| 20 | 293.15 | 0.00341 | 0.33 | 1.741 | 0.554 |
| 25 | 298.15 | 0.00335 | 0.42 | 1.543 | 0.434 |
| 30 | 303.15 | 0.00330 | 0.5 | 1.414 | 0.347 |
| 35 | 308.15 | 0.00325 | 0.59 | 1.302 | 0.264 |
| 40 | 313.15 | 0.00319 | 0.7 | 1.195 | 0.178 |
| 45 | 318.15 | 0.00314 | 0.8 | 1.118 | 0.112 |

Charge rates at various temperatures are as shown in Table 2. If the ambient temperature is 20°C, the charge rate with an SOC of 25% is 0.33 times the original charge rate; similarly, if the ambient temperature is 25°C, the charge rate with an SOC of 25% is 0.42 times the original charge rate; if the ambient temperature is 30°C, the charge rate with an SOC of 25% is 0.5 times the original charge rate; if the ambient temperature is 35°C, the charge rate with an SOC of 25% is 0.59 times the original charge rate; if the ambient temperature is 40°C, the charge rate with an SOC of 25% is 0.7 times the original charge rate; and if the ambient temperature is 45°C, the charge rate with an SOC of 25% is 0.8 times the original charge rate.

According to some embodiments of the present application, the present application further sets forth a battery including a battery cell, which is provided with corresponding electrical power after being charged using a battery charging method as described.

According to some embodiments of the present application, the present application further sets forth an electrical device, which includes a device body and a power source, where a battery as described is used as the power source.

The electrical device in the embodiments of the present application may be any of the foregoing devices or systems using a battery.

Finally, it should be noted that, the above embodiments are merely used for illustrating rather than limiting the technical solution of the present application. Although the present application has been illustrated in detail with reference to the foregoing embodiments, it should be understood by those of ordinary skill in the art that the technical solutions recorded in the foregoing embodiments may still be modified, or some or all of the technical features thereof may be equivalently substituted; and such modifications or substitutions do not make the essence of the corresponding technical solution depart from the scope of the technical solutions of the embodiments of the present application. In particular, the technical features mentioned in the embodiments can be combined in any manner as long as there is no structural conflict. The present application is not limited to specific embodiments disclosed herein, but includes all technical solutions that fall within the scope of the claims.

**Claims**

1. A battery charging method, comprising:
during charging of a battery, upon determining that a state of charge (SOC) of the battery reaches a first SOC range, adjusting a charge rate of the battery down to a second charge rate from a first charge rate within a range from a minimum boundary value of the first SOC range to a first set SOC, and adjusting the charge rate of the battery up to the first charge rate or a third charge rate from the second charge rate within a range from the first set SOC to a maximum boundary value of the first SOC range, **characterized in that** at a temperature of 25°C, current is reduced in an interval of 20%-40% SOC, and the method comprises step charging in a jagged manner in an interval of 25%-40% SOC, with a charge rate thereof being between 0.2 and 0.8 times the original charge rate in the case of 25% SOC.

2. The method according to claim 1, wherein the adjusting the charge rate of the battery up to the first charge rate or a third charge rate from the second charge rate comprises:
adjusting the charge rate of the battery up to the first charge rate from the second charge rate when the SOC of the battery reaches the range from the first set SOC to the maximum boundary value of the first SOC range.

3. The method according to claim 1, wherein the adjusting the charge rate of the battery up to the first charge rate or a third charge rate from the second charge rate comprises:
adjusting the charge rate of the battery up to the third charge rate from the second charge rate when the SOC of the battery reaches a range from the first set SOC to a third SOC; adjusting the charge rate of the battery down to the second charge rate from the third charge rate when the SOC of the battery reaches a range from the third SOC to a fourth SOC; and adjusting the charge rate of the battery up to the first charge rate from a fourth charge rate when the SOC of the battery reaches a range from the fourth SOC to the maximum boundary value of the first SOC range.

4. The method according to claim 1, wherein the adjusting the charge rate of the battery up to the first charge rate or a third charge rate from the second charge rate comprises:
adjusting the charge rate of the battery up to the third charge rate from the second charge rate when the SOC of the battery reaches the range from the first set SOC to the maximum boundary value of the first SOC range, wherein the third charge rate is greater than the first charge rate.

5. The method according to claim 4, wherein the method further comprises:
charging the battery by using a charging strategy of decreasing from a fifth charge rate to the first charge rate, when the SOC of the battery ranges from zero to the minimum boundary value of the first SOC range.

6. The method according to claim 4, wherein the method further comprises:
adjusting the charge rate of the battery up to a sixth charge rate from the third charge rate and then down to the first charge rate from the sixth charge rate, when the SOC of the battery reaches a range from the maximum boundary value of the first SOC range to a fifth SOC.

7. The method according to any one of claims 1 to 6, wherein the first set SOC ranges from 24.5% to 25.5%, and varies depending on ambient temperature.

8. The method according to claim 7, wherein the first set SOC comprises: 24.7%, 24.8%, 24.9%, 25%, 25.1%, 25.2%, or 25.3%.

9. The method according to any one of claims 1 to 8, wherein the first SOC range comprises: 20%-40%.

10. A battery 10, comprising a battery cell 210, which is provided with corresponding electrical power after being charged using a battery charging method according to any one of claims 1 to 9.

11. An electrical device, comprising a device body and a power source, wherein a battery 10 according to claim 10 ++ is used as the power source.

**Patentansprüche**

1. Batterieladeverfahren, umfassend:

während des Ladens einer Batterie, wenn bestimmt wird, dass ein Ladezustand (SOC, Engl. state of charge) der Batterie einen ersten SOC-Bereich erreicht, Anpassen eines Ladestroms der Batterie auf einen zweiten Ladestrom von einem ersten Ladestrom innerhalb eines Bereichs von einem Mindestgrenzwert des ersten SOC-Bereichs zu einem ersten eingestellten SOC, und Anpassen des Ladestroms der Batterie auf den ersten Ladestrom oder einen dritten Ladestrom von dem zweiten Ladestrom innerhalb eines Bereichs von dem ersten eingestellten SOC bis zu einem Maximalgrenzwert des ersten SOC-Bereichs,
**dadurch gekennzeichnet, dass**
bei einer Temperatur von 25 °C der Strom

in einem Intervall von 20 % bis 40 % SOC reduziert wird und das Verfahren das stufenweise Laden in einer gezackten Weise in einem Intervall von 25 % bis 40 % SOC umfasst, wobei ein Ladestrom davon zwischen dem 0,2- und dem 0,8-fachen des ursprünglichen Ladestroms in dem Fall von 25 % SOC liegt.

2. Verfahren nach Anspruch 1, wobei das Anpassen des Ladestroms der Batterie bis zu dem ersten Ladestrom oder einem dritten Ladestrom von dem zweiten Ladestrom Folgendes umfasst:
Anpassen des Ladestroms der Batterie von dem zweiten Ladestrom auf den ersten Ladestrom, wenn der SOC der Batterie den Bereich zwischen dem ersten eingestellten SOC und dem Maximalgrenzwert des ersten SOC-Bereichs erreicht.

3. Verfahren nach Anspruch 1, wobei das Anpassen des Ladestroms der Batterie bis zu dem ersten Ladestrom oder einem dritten Ladestrom von dem zweiten Ladestrom Folgendes umfasst:
Anpassen des Ladestroms der Batterie von dem zweiten Ladestrom auf den dritten Ladestrom, wenn der SOC der Batterie einen Bereich von dem ersten eingestellten SOC bis zu einem dritten SOC erreicht; Anpassen des Ladestroms der Batterie von dem dritten Ladestrom auf den zweiten Ladestrom, wenn der SOC der Batterie einen Bereich von dem dritten SOC bis zu einem vierten SOC erreicht; und Anpassen des Ladestroms der Batterie von einem vierten Ladestrom auf den ersten Ladestrom, wenn der SOC der Batterie einen Bereich von dem vierten SOC bis zu dem Maximalgrenzwert des ersten SOC-Bereichs erreicht.

4. Verfahren nach Anspruch 1, wobei das Anpassen des Ladestroms der Batterie bis zu dem ersten Ladestrom oder einem dritten Ladestrom von dem zweiten Ladestrom Folgendes umfasst:
Anpassen des Ladestroms der Batterie von dem zweiten Ladestrom auf den dritten Ladestrom, wenn der SOC der Batterie den Bereich zwischen dem ersten eingestellten SOC und dem Maximalgrenzwert des ersten SOC-Bereichs erreicht, wobei der dritte Ladestrom größer als der erste Ladestrom ist.

5. Verfahren nach Anspruch 4,
wobei das Verfahren ferner Folgendes umfasst:
Laden der Batterie unter Verwendung einer Ladestrategie, bei der von einem fünften Ladestrom auf den ersten Ladestrom gesenkt wird, wenn der SOC der Batterie zwischen Null und dem Mindestgrenzwert des ersten SOC-Bereichs liegt.

6. Verfahren nach Anspruch 4,
wobei das Verfahren ferner Folgendes umfasst:
Anpassen des Ladestroms der Batterie von dem dritten Ladestrom auf einen sechsten Ladestrom und dann von dem sechsten Ladestrom auf den ersten Ladestrom, wenn der SOC der Batterie einen Bereich zwischen dem Maximalgrenzwert des ersten SOC-Bereichs und einem fünften SOC erreicht.

7. Verfahren nach einem der Ansprüche 1 bis 6,
wobei der erste eingestellte SOC-Bereich in einem Bereich von 24,5 % bis 25,5 % liegt und in Abhängigkeit von der Umgebungstemperatur variiert.

8. Verfahren nach Anspruch 7,
wobei der erste eingestellte SOC Folgendes umfasst: 24,7 %, 24,8 %, 24,9 %, 25 %, 25,1 %, 25,2 % oder 25,3 %.

9. Verfahren nach einem der Ansprüche 1 bis 8,
wobei der erste SOC-Bereich Folgendes umfasst: 20 %-40 %.

10. Batterie 10, umfassend eine Batteriezelle 210, die nach dem Laden unter Verwendung eines Batterieladeverfahrens nach einem der Ansprüche 1 bis 9 mit entsprechender elektrischer Leistung bereitgestellt wird.

**11.** Elektrische Vorrichtung, umfassend einen Vorrichtungskörper und eine Leistungsquelle, wobei eine Batterie 10 nach Anspruch 10 als Leistungsquelle verwendet wird.

**Revendications**

**1.** Procédé de charge de batterie, comprenant :

pendant la charge d'une batterie, après avoir déterminé qu'un état de charge (SOC) de la batterie atteint une première plage de SOC, l'ajustement d'un taux de charge de la batterie vers le bas jusqu'à un deuxième taux de charge à partir d'un premier taux de charge dans une plage allant d'une valeur limite minimale de la première plage de SOC jusqu'à un premier SOC défini, et l'ajustement du taux de charge de la batterie vers le haut jusqu'au premier taux de charge ou jusqu'à un troisième taux de charge à partir du deuxième taux de charge dans une plage allant du premier SOC défini à une valeur limite maximale de la première plage de SOC,
**caractérisé en ce qu'**
à une température de 25 °C,

le courant est réduit dans un intervalle de 20 % à 40 % du SOC, et le procédé comprend une étape de charge en dents de scie dans un intervalle de 25 % à 40 % du SOC, avec un taux de charge se situant entre 0,2 et 0,8 fois le taux de charge initial dans le cas de 25 % du SOC.

**2.** Procédé selon la revendication 1, dans lequel l'ajustement du taux de charge de la batterie vers le haut jusqu'au premier taux de charge ou jusqu'à un troisième taux de charge à partir du deuxième taux de charge comprend : l'ajustement du taux de charge de la batterie vers le haut jusqu'au premier taux de charge à partir du deuxième taux de charge lorsque le SOC de la batterie atteint la plage allant du premier SOC défini à la valeur limite maximale de la première plage de SOC.

**3.** Procédé selon la revendication 1, dans lequel l'ajustement du taux de charge de la batterie vers le haut jusqu'au premier taux de charge ou jusqu'à un troisième taux de charge à partir du deuxième taux de charge comprend : l'ajustement du taux de charge de la batterie vers le haut jusqu'au troisième taux de charge à partir du deuxième taux de charge lorsque le SOC de la batterie atteint une plage allant du premier SOC défini à un troisième SOC ; l'ajustement du taux de charge de la batterie vers le bas jusqu'au deuxième taux de charge à partir du troisième taux de charge lorsque le SOC de la batterie atteint une plage allant du troisième SOC à un quatrième SOC ; et l'ajustement du taux de charge de la batterie vers le haut jusqu'au premier taux de charge à partir d'un quatrième taux de charge lorsque le SOC de la batterie atteint une plage allant du quatrième SOC à la valeur limite maximale de la première plage de SOC.

**4.** Procédé selon la revendication 1, dans lequel l'ajustement du taux de charge de la batterie vers le haut jusqu'au premier taux de charge ou jusqu'à un troisième taux de charge à partir du deuxième taux de charge comprend : l'ajustement du taux de charge de la batterie vers le haut jusqu'au troisième taux de charge à partir du deuxième taux de charge lorsque le SOC de la batterie atteint la plage allant du premier SOC défini à la valeur limite maximale de la première plage de SOC, le troisième taux de charge étant supérieur au premier taux de charge.

**5.** Procédé selon la revendication 4,
dans lequel le procédé comprend en outre :
la charge de la batterie à l'aide d'une stratégie de charge consistant à diminuer à partir d'un cinquième taux de charge jusqu'au premier taux de charge lorsque le SOC de la batterie est dans la plage allant de zéro à la valeur limite minimale de la première plage de SOC.

**6.** Procédé selon la revendication 4,
dans lequel le procédé comprend en outre :
l'ajustement du taux de charge de la batterie vers le haut jusqu'à un sixième taux de charge à partir du troisième taux de charge, puis vers le bas jusqu'au premier taux de charge à partir du sixième taux de charge lorsque le SOC de la batterie atteint une plage allant de la valeur limite maximale de la première plage de SOC à un cinquième SOC.

**7.** Procédé selon l'une quelconque des revendications 1 à 6,
dans lequel le premier SOC défini est dans la plage allant de 24,5 % à 25,5 %, et varie en fonction de la température ambiante.

8. Procédé selon la revendication 7,
dans lequel le premier SOC défini comprend : 24,7 %, 24,8 %, 24,9 %, 25 %, 25,1 % , 25,2 % ou 25,3 %.

9. Procédé selon l'une quelconque des revendications 1 à 8,
dans lequel la première plage de SOC comprend : 20 % à 40 %.

10. Batterie 10, comprenant une cellule de batterie 210, à laquelle est fournie une puissance électrique correspondante après avoir été chargée à l'aide d'un procédé de charge de batterie selon l'une quelconque des revendications 1 à 9.

11. Dispositif électrique, comprenant un corps de dispositif et une source d'énergie, dans lequel une batterie 10 selon la revendication 10 est utilisée en tant que source d'énergie.

*FIG. 1*

*FIG. 2*

20

FIG. 3

210

FIG. 4

16

*FIG. 5*

*FIG. 6*

*FIG. 7*

*FIG. 9*

*FIG. 10*

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0330981 B1

- JP 2014068467 A